# EUROPÄISCHE PATENTSCHRIFT

(11) **EP 2 973 671 B1**
(45) Veröffentlichungstag und Bekanntmachung des Hinweises auf die Patenterteilung: **02.05.2018**
(21) Anmeldenummer: 14714930.6
(22) Anmeldetag: 12.03.2014
(51) Int. Cl.: H05K 1/18

(54) **VERFAHREN ZUM HERSTELLEN EINES ELEKTRONISCHEN BAUTEILS**
METHOD FOR THE PRODUCTION OF AN ELECTRONIC SUB-ASSEMBLY
PROCÉDÉ DE FABRICATION D'UN COMPOSANT ÉLECTRONIQUE

(30) Priorität: 13.03.2013 DE 102013102542
(43) Veröffentlichungstag der Anmeldung: 20.01.2016
(73) Patentinhaber: Schweizer Electronic AG, 78713 Schramberg (DE)
(72) Erfinder: GOTTWALD, Thomas, 78655 Dunningen (DE); NEUMANN, Alexander, 78628 Rottweil (DE)
(74) Vertreter: Glawe, Delfs, Moll
(86) Internationale Anmeldenummer: PCT/EP2014/000653
(87) Internationale Veröffentlichungsnummer: WO 2014/139674

(56) Entgegenhaltungen:
- WO-A2-02/47162
- TW-A- 201 309 128
- US-A1- 2006 145 328
- US-A1- 2009 084 596

## Beschreibung

### Technisches Gebiet

Die vorliegende Erfindung betrifft ein Verfahren zum Herstellen eines elektronischen Bauteils.

### Beschreibung des Standes der Technik

Elektronische Bauteile sind bekannt. Sie umfassen in der Regel einen mehr oder minder komplexen Schichtaufbau aus (elektrisch) leitenden und nicht-leitenden Schichten und sind in oder auf der Schichtabfolge mit elektronischen Bauelementen (wie Leistungshalbleiter u.dgl.) bestückt. Die Ankontaktierung der Bauelemente erfolgt durch die Schichten des darüber liegenden Schichtaufbaus.

Die WO 02/47162 A2 offenbart einen mikroelektronischen Schichtaufbau mit mindestens einem mikroelektronischen Bauelement, das über eine Haftschicht auf einer wärmeabführenden Schicht aufgebracht ist. Das mindestens eine Bauelement ist in entsprechend mindestens einer Öffnung einer Kernschicht angeordnet, die aus leitendem oder nicht leitendem Material bestehen kann. Der Aufbau wird mit Prepreg laminiert, so dass das mindestens eine Bauelement an drei Seiten (jeweils seitlich und oben) von Harz umgeben ist.

Die US 2006/0145328 A1 offenbart einen in ein Substrat eingebetteten Chip, der in eine Ausnehmung einer Trägerschicht eingebracht ist, die aus leitendem oder nicht leitendem Material bestehen kann. Oberhalb und unterhalb des Chips sind Harzschichten angebracht. Es ist stets eine Haftklebeschicht vorgesehen. Es wird zunächst eine Prepreg-Schicht bereitgestellt, in die Löcher eingebohrt werden, um anschließend eine Verkupferung vorzunehmen.

Aus der TW 201309128 A1 und der US 2009/0084596 A1 sind Leiterplatten mit einem in einer Schichtabfolge eingebetteten elektronischen Bauelement bekannt, das in einer Ausnehmung einer elektrisch leitenden zentralen Schicht (Substrat) angeordnet ist und beiderseits an jeweils eine Harzschicht anschließt.

### Zusammenfassung der Erfindung

Erfindungsgemäß wird ein Verfahren zum Herstellen eines elektronischen Bauteils mit den Merkmalen des Anspruchs 1 vorgeschlagen.

Der erfindungsgemäße Gedanke besteht darin, ein Verfahren bereitzustellen, bei dem leistungselektronische Komponenten in ein Laminat eingebracht werden, ohne dass vorher eine elektrische Kontaktierung mindestens eines Kontaktes vorgenommen wurde.

Dies wird dadurch erzielt, dass das Bauelement in leicht erwärmtem Zustand unmittelbar auf eine elektrisch isolierende Lage bestückt wird. Gemäß der Erfindung kann somit auf einen zusätzlichen Arbeitsschritt des Lötens, Sinterns oder Klebens verzichtet werden. Die ausreichende Fixierung des bestückten Bauelements wird durch die kurzzeitige Verflüssigung und anschließende Wiedererstarrung der elektrisch isolierenden Lage zumindest im Bereich unterhalb des Bauelements erreicht.

Beim späteren Laminierprozess kann diese Schicht jedoch wieder erweichen, was zum Verlust der Positionierungsgenauigkeit führen könnte. Um dies zu verhindern, ist erfindungsgemäß als nächste Lage eine im Schichtaufbau einzubringende "Lochmaske" vorgesehen, die als "Schablone" dient und während des Verpressens das Bauelement in seiner Position hält. Diese Lage umfasst mindestens eine Ausnehmung, deren Dimensionen an denen des aufzunehmenden Bauelements orientiert sind, so dass die Ausnehmung das Bauelement eng umschließt und ein Verrutschen während der weiteren Verarbeitung unterbindet. Darüber hinaus dient diese Lage zur Gestaltung eines Entwärmungspfades mit geringem Widerstand sowie zur niederohmigen Anbindung des Bauelements an den Hochstrompfad.

Hieraus ergibt sich die Möglichkeit eines symmetrischen Schichtaufbaus, so dass das mindestens eine Bauelement in einer "nach oben" und "nach unten" identischen Schichtabfolge eingebettet ist. Korrelierende Schichten können jeweils gleich bemessen sein, so dass sich Spannungsunterschiede zwischen Bereichen "oberhalb" und "unterhalb" des Bauelements weitestgehend ausgeschlossen sind. Dadurch wird ein Verbiegen von dünnen Bauelementen (Halbleitern) unterbunden.

Selbstverständlich kann die Reihenfolge der Bestückung mit mindestens einem elektronischen Bauelement und dem Verlegen der "Lochmaske" im Rahmen der Erfindung umgekehrt werden, indem zunächst die Lochmaske auf die elektrisch isolierende Lage aufgebracht und anschließend das mindestens eine Bauelement in die mindestens eine dazu vorgesehene entsprechende Ausnehmung der "Lochmaske" eingesetzt wird. Um eine flächige Positionierung der Lochmaske auf der elektrisch isolierenden Lage zu erzielen, kann die Lochmaske bei dem Aufsetzen auf die elektrisch isolierende Lage leicht erwärmt sein, um den gleichen Effekt wie voranstehend im Zusammenhang mit der Bestückung mit dem elektronischen Bauelement beschrieben zu erzielen.

Aus der Tatsache, dass das mindestens eine Bauelement in eine das Bauelement vollständig umgebende Blechschicht von im wesentlichen gleicher Dicke eingebracht ist, resultiert des weiteren ein geringer thermischer Widerstand bei hoher thermischer Kapazität.

Des weiteren wird die Anfälligkeit durch Wegfall einer Verbindungsstelle (d.h. Löt- bzw. Sinter- oder Klebstelle) unter dem Bauelement deutlich reduziert.

Weitere Vorteile und Ausgestaltungen der Erfindung ergeben sich aus der Beschreibung und der beiliegenden Zeichnung.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist zur Veranschaulichung anhand von Ausführungsbeispielen in der Zeichnung stark schematisch und nicht maßstabsgetreu dargestellt und wird im folgenden unter Bezugnahme auf die Zeichnung ausführlich beschrieben.

### Kurzbeschreibung der Zeichnung

Figur 1 zeigt ein Ausgangssubstrat für ein elektronisches Bauteil der Erfindung.
Figur 2 zeigt das Ausgangssubstrat der Figur 1 mit aufgelegter elektrisch isolierender Lage.
Figur 3 zeigt die Schichtabfolge der Figur 2 mit bestücktem elektronischen Bauelement.
Figur 4A zeigt die Schichtabfolge der Figur 3 mit aufgebrachter elektrisch leitender Schicht mit Ausnehmung.
Figur 4B zeigt die Schichtabfolge der Figur 4A mit einer alternativen Ausgestaltung der elektrisch leitenden Schicht mit Ausnehmung.
Figur 4C zeigt die Schichtabfolge der Figur 4A mit einer weiteren alternativen Ausgestaltung der elektrisch leitenden Schicht mit Ausnehmung.
Figur 5 zeigt die Schichtabfolge der Figur 4A mit beiderseits aufgebrachten Prepreg- und Kupferlagen.
Figur 6 zeigt die Schichtabfolge der Figur 5 nach dem Verpressen.
Figur 7 zeigt die Schichtabfolge der Figur 6 mit beiderseits eingebrachten Sacklöchern zur Ankontaktierung.
Figur 8 zeigt die die Schichtabfolge der Figur 7 mit ausplattierten bzw. gefüllten Sacklöchern.
Figur 9 zeigt eine Anordnung von Transistoren gemäß dem Stand der Technik.
Figur 10 zeigt eine Anordnung von Transistoren gemäß der Erfindung.

### Ausführliche Beschreibung

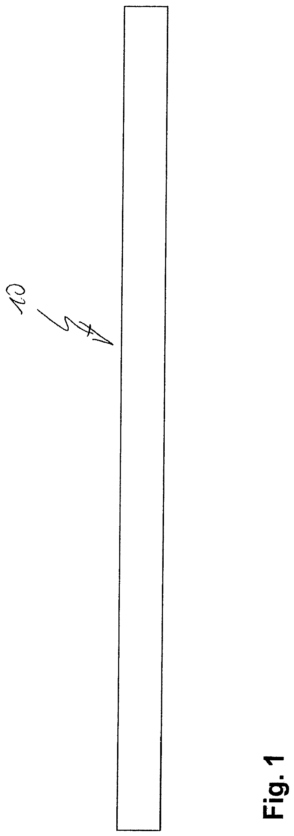

Figur 1 zeigt ein Ausgangssubstrat 10 für ein elektronisches Bauteil gemäß der Erfindung. Das Ausgangssubstrat 10 ist aus einem elektrisch leitenden Material. Es kann sich dabei um ein Kupferblech handeln. Alternativ kann es sich auch um ein Substrat aus einem Material mit einem geringen Wärmeausdehnungskoeffizienten, z.B. aus einer geeigneten Eisen-Nickel-Legierung, das beiderseits mit Kupfer bedeckt ist. Ein Beispiel hierfür ist ein Kupfer-Invar®-Kupfer-Blech (CIC-Blech), wie es im Handel vorgefertigt erhältlich ist. Typische Dicken einer solchen fertig erhältlichen CIC-Schicht sind 150 µm Invar® und jeweils 18 µm Kupfer.

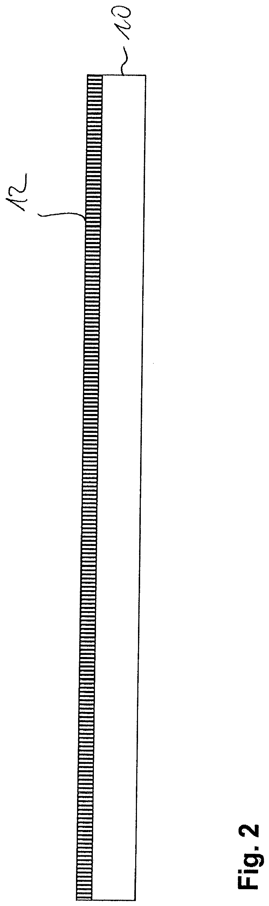

In einem nächsten Schritt wird auf das Ausgangssubstrat 10 eine erste Schicht 12 aus elektrisch isolierendem Material aufgelegt (vgl. Figur 2). Bei dieser Schicht handelt es sich um eine Schicht aus einem harzhaltigen und aushärtbaren Material, wie dies in der Herstellung elektronischer Bauteile gut bekannt ist. Der Fachmann bezeichnet ein derartiges Material auch als Prepreg, der englischen Kurzbezeichnung für "preimpregnated fibres" (vorimprägnierte Fasern).

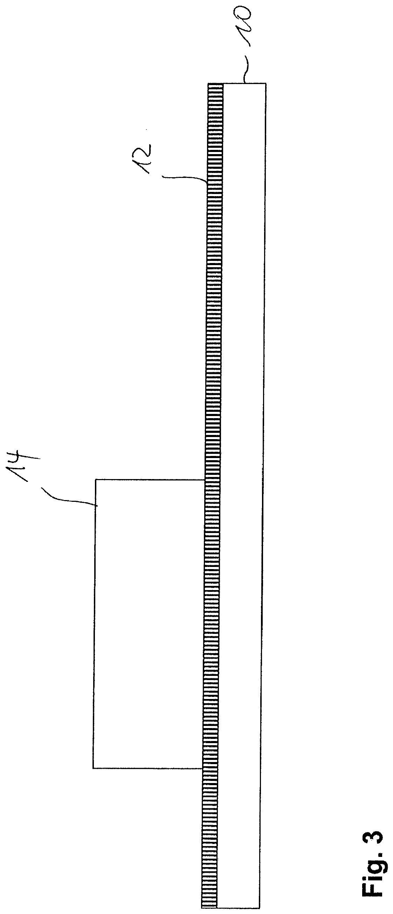

Die erste Schicht 12 aus elektrisch isolierendem Material wird dann direkt mit einem Bauelement 14 (wie bspw. einem Leistungsbauelement, Halbleiterchip) bestückt, wie dies in Figur 3 veranschaulicht ist.

Erfindungsgemäß ist das Bauelement 14 bei der Bestückung leicht erwärmt. Bei einer derartigen erfindungsgemäßen Bestückung wird die Tatsache ausgenutzt, dass das Harzmaterial der ersten Schicht 12 aus elektrisch isolierendem Material (in der Folge der Einfachheit halber als Prepreg-Schicht bezeichnet) sich bei erhöhter Temperatur verflüssigt; wird nun ein erwärmtes Bauelement 14 auf die Prepreg-Schicht 12 platziert, dann hat dies eine auf den Bereich unterhalb des Bauelement 14 beschränkte Teilverflüssigung des Prepreg-Materials zur Folge, gefolgt von einer Wiedererstarrung nach Abkühlung, wodurch das Bauelement angeheftet bzw. angebracht werden kann. Somit wird das Bauelement 14 lediglich durch Erwärmung und ohne weitere Hilfsmittel (wie Klebmittel o.dgl.) an der gewünschten Stelle für die weitere Be- bzw. Verarbeitung ausreichend fixiert. Die Erwärmung des Bauelements 14 erfolgt bspw. mittels eines beheizten Bestückungswerkzeugs, wie bspw. eine sogenannte Thermode.

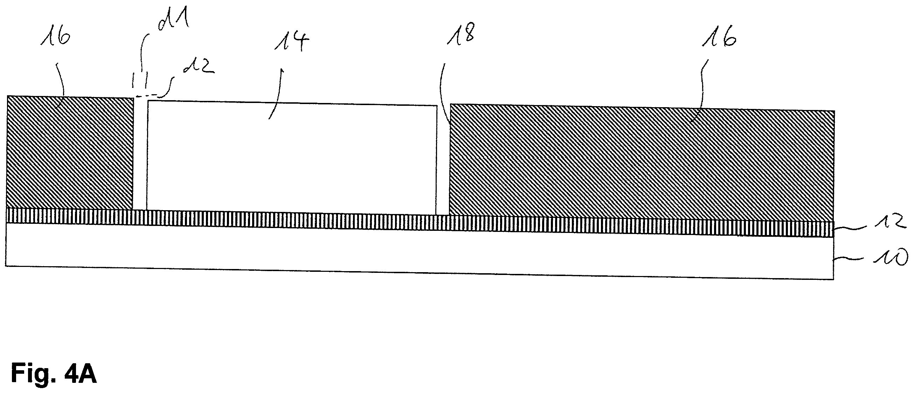

In einem nächsten Schritt wird eine erste elektrisch leitende Schicht 16 mit mindestens einer Ausnehmung 18 verlegt. Bei dieser Schicht 16 kann es sich bspw. um eine "Lochmaske" bzw. Schablone handeln, die bspw. aus einem Kupferblech o.dgl. besteht. Die mindestens eine Ausnehmung 18 ist in ihrer Anordnung und ihren Dimensionen auf das mindestens eine bestückte Bauelement 14 ausgelegt (vgl. Figur 4A). Oder mit anderen Worten: die Breite und Tiefe (also die Erstreckung in X-Y-Richtung) der Ausnehmung 18 entsprechen Breite und Tiefe des Bauelements 14 zuzüglich einer Positionierungstoleranz d1, und die Höhe der Ausnehmung 18 (also deren Materialdicke) entspricht der Höhe des Bauelements 14 zuzüglich einer Ausgleichstoleranz d2 für den beim anschließenden Verpressen auftretenden (leichten) Höhenschwund der ersten elektrisch leitenden Schicht 16 (und zur Druckentlastung des Bauelements 14 beim Verpressvorgang).

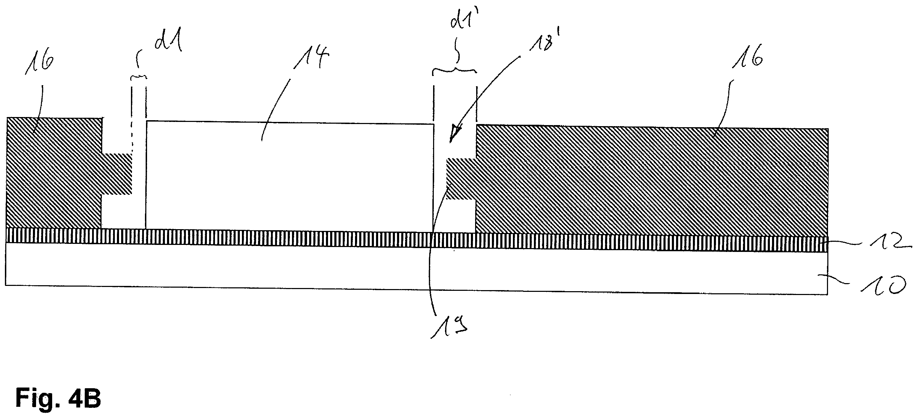

Figur 4B zeigt eine alternative Ausgestaltung der "Lochmaske" bzw. Schablone, in der die Ausnehmung 18' der elektrisch leitenden Schicht 16 eine Abstufung bzw. einen schulterförmigen Querschnitt aufweist. Einerseits soll die Ausnehmung der "Lochmaske" zwar beabstandet, aber so eng wie möglich an dem Bauelement (Chip) 14 anliegen, um eine Fixierung des Bauelements in der weiteren Verarbeitung zu gewährleisten. Andererseits besteht jedoch die Gefahr, dass bei zu geringem Abstand d1 zwischen Bauelement 14 und elektrisch leitender Schicht 16 ein Stromdurchschlag auftritt. Um dies zu vermeiden, wird die Ausnehmung 18' zur Oberseite und Unterseite der elektrisch leitenden Schicht hin mit einem größeren Durchmesser ausgestaltet, so dass sich der Abstand zwischen Bauelement 14 und elektrisch leitender Schicht 16 an den leitenden Flächen des Bauelements so stark vergrößert, dass eine Durchschlagsgefahr auszuschließen bzw. stark verringert ist. In einem mittleren Bereich der elektrisch leitenden Schicht 16 bleibt der geringere Abstand d1 aufgrund des Vorsprungs 19 der genannten Abstufung erhalten, so dass die Fixierungsfunktion weiterhin erfüllt ist. Der Begriff "Durchmesser" ist hierbei im Blick auf die Querschnittsdarstellung der Figuren gewählt und ist nicht so zu verstehen, dass die Ausnehmung rund ist; vielmehr kann die Ausnehmung jede beliebige Form aufweisen, wie bspw. rechteckig, vieleckig, unregelmäßig o.dgl.

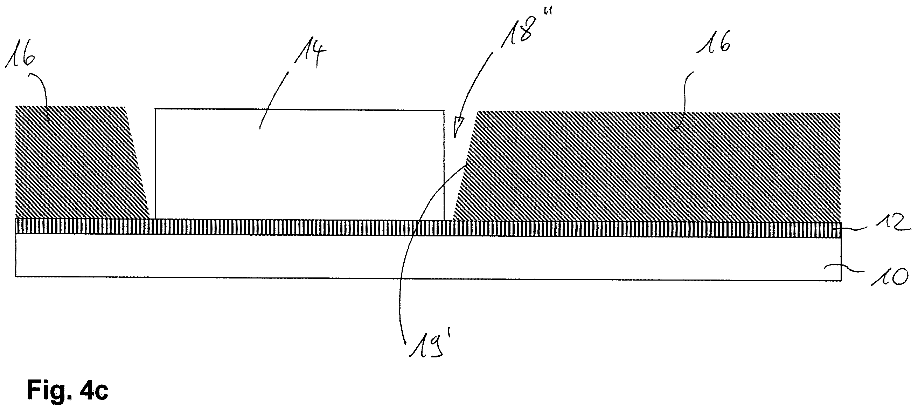

Es ist zu betonen, dass die Ausgestaltung des Vorsprungs 19 nicht auf die in der Figur 4B dargestellte Form beschränkt ist und andere Formen möglich sind und sich dem Fachmann erschließen. Insbesondere ist eine Ausgestaltung mit schräg verlaufenden (trichterförmigen) Flächen 19' denkbar, die ein nachträgliches Einsetzen des Bauelements erleichtern, wie dies bspw. anhand der Ausnehmung 18" der in Figur 4C dargestellten Ausführungsform veranschaulicht ist. Auch eine "Doppeltrichterform" ist möglich. Die Darstellungen in den Figuren 4B und 4C sind stark schematisch und dienen lediglich zu Anschauungszwecken; die dargestellten Dimensionen sind nicht maßstabsgetreu und stark überhöht.

Die Positionierungstoleranz d1 kann bspw. bei sogenannten Hochpräzisions-Chipshootern in der Größenordnung von 3µm und bei Hochgeschwindigkeitsbestückern in der Größenordnung von ca. 25 bis 50µm liegen. Die Abmessungen der Aussparung liegen typischerweise in der Größenordnung von 50 bis 100µm, wegen der Genauigkeit des Verlegens der Schablone selbst. Die Ausgleichstoleranz d2 kann bspw. 0 bis 30 µm betragen, um die das Blech der Lochmaske 16 dicker gewählt wird. Die Dicke (also Höhe) der ersten elektrisch leitenden Schicht 16 kann mit relativ geringem Aufwand (bspw. durch Walzen oder galvanische Abscheidung oder in Kombination mit einem galvanisch erzeugten Aufbau) an die Höhe des Bauelements angepasst werden.

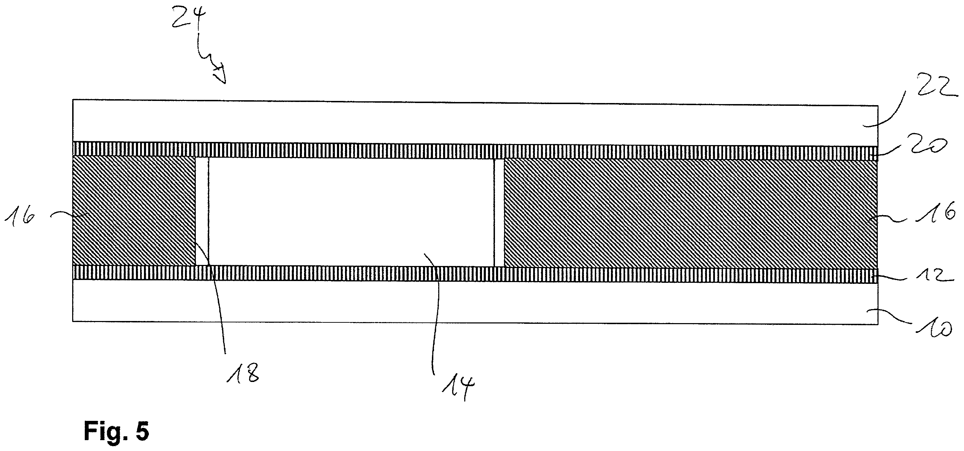

Anschließend werden eine zweite Schicht 20 aus elektrisch isolierendem Material und mindestens eine zweite elektrisch leitende Schicht 22 aufgebracht, wie dies in Figur 5 veranschaulicht ist. Bei der zweiten Schicht 20 aus elektrisch isolierendem Material kann es sich wiederum um eine Prepreg-Lage mit erhöhter thermischer Leitfähigkeit handeln, und bei der zweiten elektrisch leitenden Schicht 22 um eine Kupferschicht oder eine CIC-Lage (wie voranstehend beschrieben). Die so erhaltene Schichtabfolge 24 wird dann in üblicher Weise verpresst/laminiert.

Erfindungsgemäß wird die Schichtabfolge 24 so gestaltet, dass sich ein symmetrischer Aufbau ergibt, d.h. eines in einer zentralen Schicht 16 (der ersten elektrisch leitenden Schicht) eingebetteten Bauelements 14, das beiderseits (d.h. in den beiden Richtungen senkrecht zur Haupterstreckungsebene der Struktur und somit des Bauelements und der zentralen Schicht) mit einer Prepreg-Lage 12, 20 und darauf befindlichen leitenden Schichten 10, 22 (dem Ausgangssubstrat und der zweiten elektrisch leitenden Schicht) bedeckt ist.

Wie auch aus den Darstellungen des Figuren entnommen werden kann, sind die Flächen, mit denen das mindestens eine Bauelement jeweils nach oben und nach unten in Kontakt steht, einheitlich, d.h. es bestehen keine bzw. nur geringe Unterschiede, so dass Unterschiede in der Oberflächenspannung minimiert werden. Dadurch können Wölbungen der eingebetteten Bauelemente deutlich reduziert und weitestgehend vermieden werden.

In diesem Zusammenhang sei darauf hingewiesen, dass im Rahmen der vorliegenden Anmeldung die Begriffe "oben" und "unten" im Hinblick auf die in den Figuren dargestellte Orientierung des Bauelements und der Schichtenabfolge zu verstehen sind. Selbstverständlich handelt es sich um relative Bezeichnungen, die sich grundsätzlich ändern, wenn die Schichtabfolge gedreht wird, was im Hinblick auf den erfindungsgemäß symmetrischen Aufbau jedoch ohne Folge bleibt. Dies erschließt sich dem Fachmann jedoch ohne weiteres.

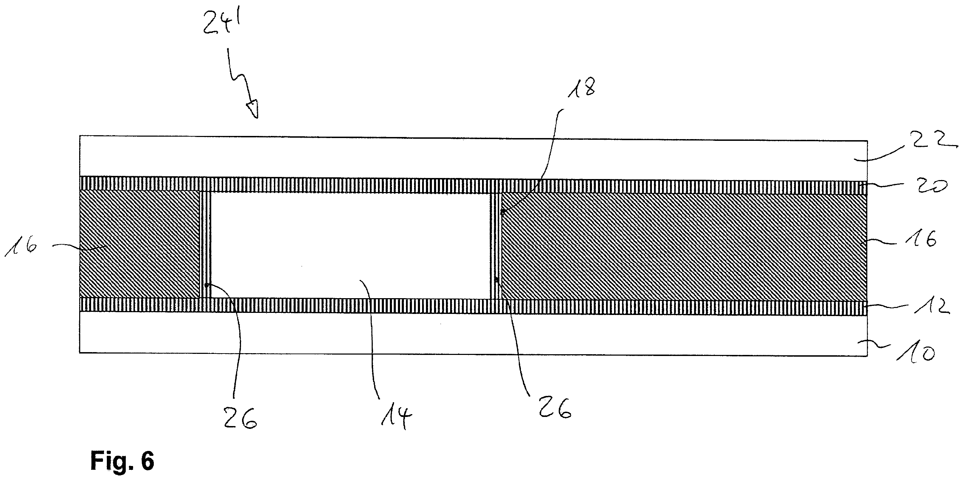

Der verpresste Zustand 24' der Schichtabfolge 24 ist in Figur 6 dargestellt. Während des Verpressens wird das Bauelement 14 von der eng bemaßten Ausnehmung 18 der ersten elektrisch leitenden Schicht 16 in seiner Position gehalten und verflüssigtes Harz der beiderseits des Bauelements 14 befindlichen Prepreg-Lagen 12, 20 dringt in die Zwischenräume d1 zwischen Bauelement 14 und erster elektrisch leitenden Schicht 16. Das verflüssigte Harz härtet anschließend aus und füllt dann die besagten Zwischenräume mit festem Material 26.

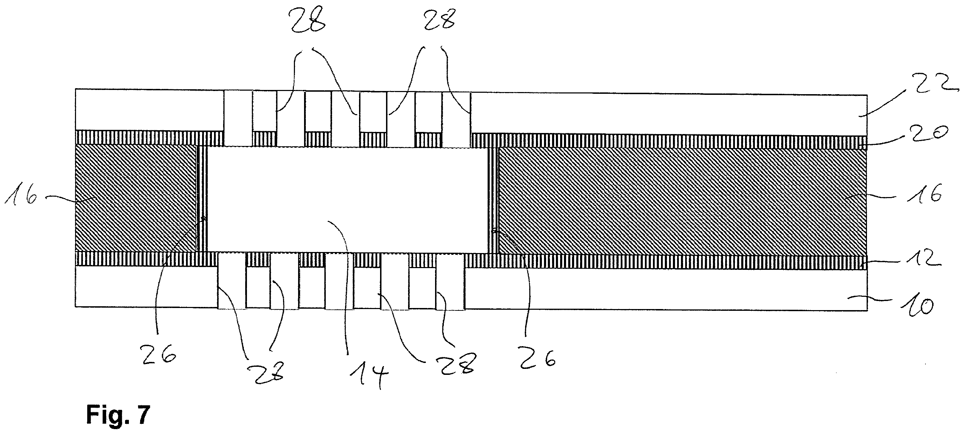

Figur 7 zeigt, wie in einem folgenden Schritt beiderseits auf die beiden Oberflächen des Bauelements 14 führende Sacklöcher 28 in die Schichten 10, 12 bzw. 20, 22 eingebracht werden. Dies erfolgt in dem Fachmann an sich bekannter Art und Weise, bspw. durch einen Laserprozess oder durch einen Ätzprozess. Als besonders vorteilhaft erweist sich, dass die Ankontaktierung des mindestens einen Bauelements erfindungsgemäß vollständig nach dem Einbetten erfolgt und ein vorhergehender Aufbau- und Verbindungsprozess entfällt.

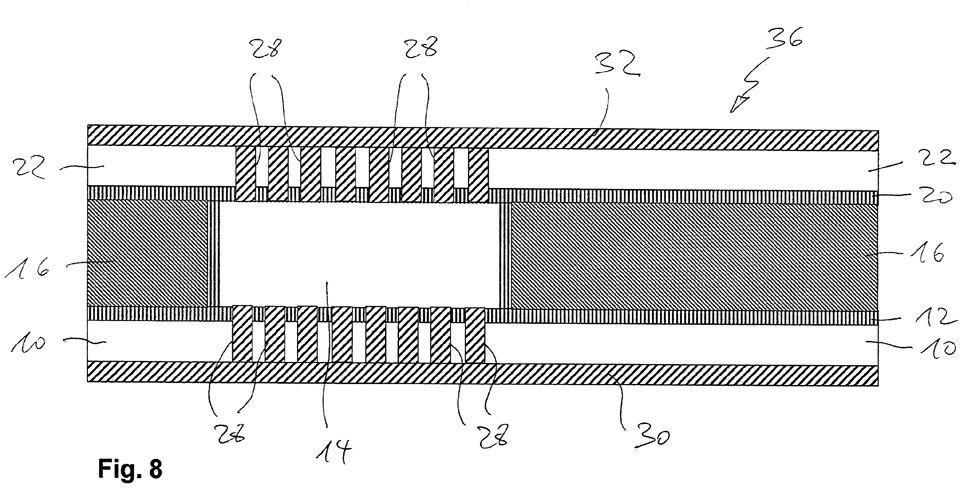

Die Sacklöcher 28 zur Ankontaktierung des Bauelements 14 werden dann mit einem leitenden Material wie insb. Kupfer ausgefüllt. Dies erfolgt z.B. durch einen Plattierungsprozess, bei dem beidseitig der Schichtabfolge auf den äußersten leitenden Schichten 10, 22 jeweils eine Kupferschicht 30, 32 aufgebracht wird, die auch die Sacklöcher 28 füllt (vgl. Figur 8). Hierfür verfügt das mindestens eine Bauelements über eine Oberfläche, die eine galvanische Ankontaktierung mit ausreichend hoher Haftung erlaubt, wie z.B. Kupfer. Die aufgebrachten Kupferschichten 30, 32 werden dann abhängig von der weiteren Gestaltung der Leiterplattenfunktion einer sogenannten photolithographischen Strukturierung unterzogen, d.h. ein Resistauftrag gefolgt von einem Belichtungs-, Entwicklungs- und einem Ätzprozess, um bspw. die nachfolgend beschriebene Transistorenanordnung auszubilden. Hierbei handelt es sich um ein dem Fachmann geläufiges Vorgehen.

Wie den Darstellungen der Figuren 7 und 8 entnehmbar ist, zeichnet sich die Schichtabfolge der Erfindung auch nach Anbringung und Ausfüllung der Durchkontaktierungslöcher 28 durch eine Schichtsymmetrie mit dem Bauelement 14 in der Mitte aus.

Diese Schichtsymmetrie kann erfindungsgemäß für einen vorteilhaften Aufbau des elektronischen Bauteils, d.h. beim Design des Bauteils, genutzt werden, wie nachfolgend beschrieben wird.

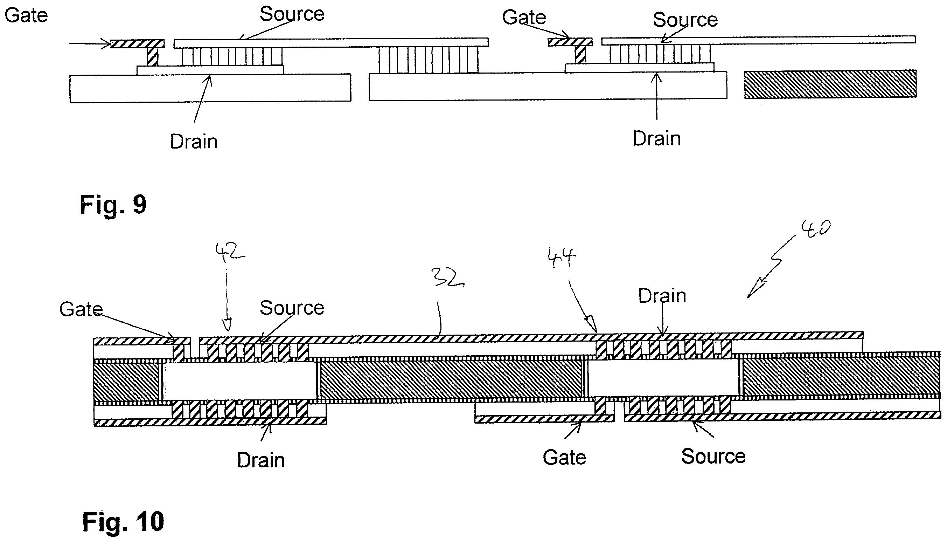

Üblicherweise ist bei der Gestaltung von elektronischen Bauteilen, die mit aktiven Elementen (wie z.B. MOS-FET-Transistoren) zu bestücken sind, zu berücksichtigen, dass die mindestens drei Anschlüsse (Gate, Source, Drain) eines derartigen Elements auf gegenüberliegenden Seiten des Elements liegen und so bei einer Bestückung mit mehreren Elementen/Transistoren (bspw. zur Realisierung einer Brückenschaltung) ein umständlicher Aufbau mit zusätzlichen Durchkontaktierungen bzw. zusätzlichen Verbindungen oberhalb der Elemente notwendig ist. Ein derartiger bekannter Aufbau ist in Figur 9 schematisch dargestellt.

Die Erfindung ermöglicht einen deutlich vereinfachten Aufbau, da nun eine beidseitige Ankontaktierung des Bauelements möglich ist, mit der Folge, dass Bauelemente alternierend (also bspw. Drain oben/Source unten, gefolgt von Drain unten/Source oben usw.) angeordnet werden können.

Dies ist in Figur 10 veranschaulicht. Figur 10 zeigt einen erfindungsgemäß erzielten Schichtaufbau 40 mit zwei Transistor-Bauelementen 42, 44 (in der Folge vereinfacht Transistoren genannt).

Der in der Darstellung der Figur 10 links liegende erste Transistor 42 weist mit seinem Drain-Anschluss D1 nach unten und mit seinen Gate- und Source-Anschlüssen G1, S1 nach oben. Die Anschlüsse D1, G1, S1 sind wie voranstehend beschrieben mit aus Sacklöchern 28 gebildeten Durchkontaktierungen ankontaktiert. Der in der Darstellung der Figur 10 rechts liegende zweite Transistor 44 weist mit seinem Drain-Anschluss D2 nach oben, während die Gate- und Source-Anschlüsse G2, S2 entsprechend nach unten weisen. Die beiden Transistoren 42, 44 sind somit in ihrer Orientierung alternierend zueinander angeordnet.

Wie aus der Darstellung der Figur 10 erkennbar ist, können somit die Source- und Drain-Anschlüsse aufeinanderfolgender Transistoren einfach miteinander verbunden werden, da sie nun auf einer Verbindungsebene liegen. In dem dargestellten Beispiel bedeutet dies, dass der Source-Anschluss S1 des ersten Transistors 42 über die Ebene der aufplattierten Schicht 32 einfach mit dem Drain-Anschluss D2 des zweiten Transistors 44 verbunden werden kann.

Die alternierende Ausrichtung (in vertikaler Orientierung, d.h. entlang einer Längserstreckung des elektronischen Bauteils 40 bzw. einer durch das elektronische Bauteil 40 aufgespannten Ebene, wie dies durch die Darstellung der Figur 10 veranschaulicht ist) der Transistoren kann auch als "face up/face down"-Anordnung beschreiben werden.

Die Schablone oder Lochmaske der ersten elektrisch leitenden Schicht 16 (der zentralen Schicht im fertigen elektronischen Bauteil) kann durch eine Kombination von Durchbrüchen und Haltestegen in Segmente unterteilt sein. Nach dem erfolgten Einlaminieren (Verpressen) können die Haltestege von außen entfernt werden, wodurch Bereiche entstehen, die an unterschiedliche Potentiale angeschlossen werden können. Die Haltestege sind mit in den Schichtaufbau einlaminiert und werden mit dem Schritt des Durchbohrens des Gesamtaufbaus entfernt. Der Bohrdurchmesser entspricht hierfür mindestens der Steglänge. Durch diese Maßnahme kann die zentrale leitende Schicht nach Fertigstellung der Schaltungsanordnung zum Transport hoher Ströme mit geringem Widerstand verwendet werden. Durch Stromführung im Inneren (also der zentralen leitenden Schicht) des elektronischen Bauteils und in mindestens einer der äußeren Lagen kann eine sehr niederinduktive Anbindung erreicht werden, die für den Betrieb der Schaltung mit geringen Verlusten vorteilhaft ist.

Eine Einbindung der "Schablone" 16 in die elektrische Funktionalität des elektronischen Bauteils kann bspw. durch Ankontaktierung einer Außenlage mit einem gewünschten Teilbereich der Schicht 16 erfolgen, z.B. mittels Sacklöchern (nicht näher dargestellt). Dem Fachmann erschließen sich ggf. auch andere Methoden der Ankontaktierung.

Das fertige elektronische Bauteil stellt sich aufgrund der erfindungsgemäßen beidseitigen Ankontaktierung des mindestens einen eingebetteten elektronischen Bauelements nach außen als nicht potentialfrei dar. Es ist daher in der Regel noch eine elektrische Isolierung notwendig, bspw. gegenüber einem noch vorzusehenden (nicht beschriebenen und nicht dargestellten) an sich bekannten Kühlkörper. Weitere Möglichkeiten sind das Vorsehen einer isolierenden Lage mittels eines sogenannten thermischen Interface-Materials (TIM) oder mindestens einer weiteren isolierenden Lage mittels zusätzlichen Verpresses. Beim Verbauen des fertigen elektronischen Bauteils in einer Leiterplatte erfolgt die elektrische Isolierung durch die Einbettung in die elektrisch isolierenden Lagen des Leiterplattenaufbaus. Gegebenenfalls notwendige Maßnahmen hierfür sind dem Fachmann geläufig.

## Patentansprüche

1. Verfahren zum Herstellen eines elektronischen Bauteils (36, 40) mit den folgenden Schritten:
- Bereitstellen eines elektrisch leitenden Ausgangssubstrats (10),
- Auflegen mindestens einer ersten Schicht (12) aus elektrisch isolierendem Material,
- Bestücken mit mindestens einem Bauelement auf die erste Schicht aus elektrisch isolierendem Material (14; 42, 44),
- Verlegen einer ersten elektrisch leitenden Schicht (16) auf die erste Schicht aus elektrisch isolierendem Material mit mindestens einer Ausnehmung (18, 18), wobei die mindestens eine Ausnehmung (18, 18') in ihrer Anordnung und ihren Dimensionen auf das mindestens eine Bauelement (14; 42, 44) ausgelegt ist, derart dass das elektronische Bauelement (14; 42, 44) in der Ausnehmung (18, 18') angeordnet ist,
wobei der Schritt des Bestückens mit mindestens einem Bauelement (14; 42, 44) von dem Schritt des Verlegens der ersten elektrisch leitenden Schicht (16) gefolgt wird, wobei das mindestens eine Bauelement (14; 42, 44) im Moment des Bestückens eine erhöhte Temperatur aufweist, oder bei dem der Schritt des Verlegens der ersten elektrisch leitenden Schicht (16) von dem Schritt des Bestückens mit mindestens einem Bauelement (14; 42, 44) gefolgt wird, wobei die erste elektrisch leitende Schicht (16) im Moment des Bestückens eine erhöhte Temperatur aufweist,
- Aufbringen mindestens einer zweiten Schicht (20) aus elektrisch isolierendem Material und mindestens einer zweiten elektrisch leitenden Schicht (22) auf das Bauelement, und
- Verpressen der so erzeugten Schichtabfolge (24).

2. Verfahren nach Anspruch 1, bei dem das Bauelement (14; 42, 44) ein Leistungshalbleiter ist und/oder die Bestückung mittels einer Thermode erfolgt.

3. Verfahren nach Anspruch 1 oder 2, bei dem das Bauelement (14; 42, 44) und die erste elektrisch leitende Schicht (16) eine im wesentlichen gleiche Höhe aufweisen, oder bei dem die erste elektrisch leitende Schicht (16) im wesentlichen die gleiche Höhe wie das Bauelement (14; 42, 44) zuzüglich einer Ausgleichstoleranz (d2) aufweist.

4. Verfahren nach einem der Ansprüche 1 bis 3, bei dem die mindestens eine Ausnehmung (18, 18') der ersten elektrisch leitenden Schicht (16) in ihren Abmessungen in Breite und Tiefe zumindest abschnittsweise den Abmessungen des Bauelements (14; 42, 44) zuzüglich einer Positionstoleranz (d1) entspricht.

5. Verfahren nach einem der Ansprüche 1 bis 4, mit dem darauffolgenden Schritt des beidseitigen Einbringens von Durchkontaktierungen (28, 30, 32) auf das Bauelement (14; 42, 44).

6. Verfahren nach Anspruch 5, bei dem die Durchkontaktierungen (28, 30, 32) mittels Laserbohren und anschließendem galvanischem Aufplattieren oder mittels Ätzen der Kupferlagen und Laserbohren des Dielektrikums und anschließendem galvanischem Aufplattieren erzeugt werden.

7. Verfahren nach einem der Ansprüche 1 bis 6, bei dem der Schritt des Bestückens das Bestücken mit mindestens zwei Leistungshalbleitern (42, 44) umfasst, die mit ihren Anschlüssen (D1, G1, S1; D2, G2, S2) in vertikaler Ausrichtung alternierend zueinander angeordnet sind.

## Claims

1. Method for producing an electronic sub-assembly (36, 40) with the following steps:
- providing an electrically conducting starting substrate (10);
- placing on at least one first layer (12) of electrically insulating material;
- mounting at least one component on the first layer of electrically insulating material (14; 42, 44);
- laying a first electrically conducting layer (16) onto the first layer of electrically insulating material, with at least one recess (18, 18'), the at least one recess (18, 18') being designed in its arrangement and dimensions to match the at least one component (14; 42, 44) in such a way that the electronic component (14; 42, 44) is arranged in the recess (18, 18'),
wherein the step of mounting at least one component (14; 42, 44) is followed by the step of laying the first electrically conducting layer (16), the at least one component (14; 42, 44) having an elevated temperature at the moment of mounting, or in which the step of laying the first electrically conducting layer (16) is followed by the step of mounting at least one component (14; 42, 44), the first electrically conducting layer (16) having an elevated temperature at the moment of mounting,
- applying at least one second layer (20) of electrically insulating material and at least one second electrically conducting layer (22) to the component, and
- pressing the sequence of layers (24) thus created.

2. Method according to Claim 1, in which the component (14; 42, 44) is a power semiconductor and/or the mounting is performed by means of a thermode.

3. Method according to Claim 1 or 2, in which the component (14; 42, 44) and the first electrically conducting layer (16) are essentially of the same height, or in which the first electrically conducting layer (16) is essentially of the same height as the component (14; 42, 44) plus an equalizing tolerance (d2).

4. Method according to one of Claims 1 to 3, in which the at least one recess (18, 18') of the first electrically conducting layer (16) corresponds in its dimensions in width and depth at least in certain portions to the dimensions of the component (14; 42, 44) plus a positional tolerance (d1).

5. Method according to one of Claims 1 to 4, with the then-following step of introducing vertical interconnect accesses (28, 30, 32) into both sides of the component (14; 42, 44).

6. Method according to Claim 5, in which the vertical interconnect accesses (28, 30, 32) are created by means of laser drilling and subsequent electroplating or by means of etching the copper layers and laser drilling the dielectric and subsequent electroplating.

7. Method according to one of Claims 1 to 6, in which the step of mounting comprises mounting at least two power semiconductors (42, 44), which are arranged with their terminals (D1, G1, S1; D2, G2, S2) alternating with one another in vertical alignment.

## Revendications

1. Procédé de réalisation d'un élément structurel électronique (36, 40), comprenant les étapes suivantes consistant à :
- préparer un substrat de départ (10) électriquement conducteur,
- déposer au moins une première couche (12) en un matériau électriquement isolant,
- agencer au moins un composant sur la première couche en matériau électriquement isolant (14 ; 42, 44),
- poser une première couche électriquement conductrice (16) sur la première couche en matériau électriquement isolant, présentant au moins un évidement (18, 18'), ledit au moins un évidement (18, 18') étant conçu pour ledit au moins un composant (14 ; 42, 44) quant à sa disposition et à ses dimensions de telle sorte que le composant électronique (14 ; 42, 44) est agencé dans l'évidement (18, 18'),
dans lequel
l'étape d'agencement dudit au moins un composant (14 ; 42, 44) est suivie par l'étape de pose de la première couche électriquement conductrice (16), et ledit au moins un composant (14 ; 42, 44) présente une température accrue à l'instant de l'agencement, ou
l'étape de pose de la première couche électriquement conductrice (16) est suivie par l'étape de l'agencement dudit au moins un composant (14 ; 42, 44), la première couche électriquement conductrice (16) présentant une température accrue à l'instant de l'agencement,
- déposer au moins une seconde couche (20) en matériau électriquement isolant et au moins une seconde couche électriquement conductrice (22) sur le composant, et
- comprimer la succession de couches (24) ainsi générée.

2. Procédé selon la revendication 1,
dans lequel
le composant (14 ; 42, 44) est un semi-conducteur de puissance et/ou l'agencement s'effectue à l'aide d'une thermode.

3. Procédé selon la revendication 1 ou 2,
dans lequel
le composant (14 ; 42, 44) et la première couche électriquement conductrice (16) présentent une hauteur sensiblement égale, ou
la première couche électriquement conductrice (16) présente sensiblement la même hauteur que le composant (14 ; 42, 44), en sus d'une tolérance de compensation (d2).

4. Procédé selon l'une des revendications 1 à 3,
dans lequel
ledit au moins un évidement (18, 18') de la première couche électriquement conductrice (16) correspond, quant à ses dimensions en largeur et en profondeur, au moins localement aux dimensions du composant (14 ; 42, 44), en sus d'une tolérance de position (d1).

5. Procédé selon l'une des revendications 1 à 4,
comprenant ensuite l'étape consistant à aménager des trous métallisés (28, 30, 32) dans le composant (14 ; 42, 44).

6. Procédé selon la revendication 5,
dans lequel les trous métallisés (28, 30, 32) sont réalisés par perçage au laser et ensuite par plaquage galvanique ou par attaque des couches de cuivre et par perçage au laser du diélectrique et ensuite par plaquage galvanique.

7. Procédé selon l'une des revendications 1 à 6, dans lequel l'étape de l'agencement comprend l'agencement d'au moins deux semi-conducteurs de puissance (42, 44) qui ont leurs bornes (D1, G1, S1 ; D2, G2, S2) agencées en alternance les unes avec les autres en orientation verticale.
